# Europäisches Patentamt

## European Patent Office

## Office européen des brevets

(19)

(11) Veröffentlichungsnummer: **0 226 887**

**B1**

(12) **EUROPÄISCHE PATENTSCHRIFT**

(45) Veröffentlichungstag der Patentschrift: **17.10.90**

(51) Int. Cl.⁵: **G 01 R 31/30**

(21) Anmeldenummer: **86116679.1**

(22) Anmeldetag: **01.12.86**

(54) **Verfahren und Schaltungsanordnung zur Prüfung von integrierten Schaltungen.**

(30) Priorität: **03.12.85 DE 3542731**

(43) Veröffentlichungstag der Anmeldung:
**01.07.87 Patentblatt 87/27**

(45) Bekanntmachung des Hinweises auf die
Patenterteilung:
**17.10.90 Patentblatt 90/42**

(84) Benannte Vertragsstaaten:
**AT BE CH DE FR GB IT LI NL**

(56) Entgegenhaltungen:
**US-A-3 577 073**

(73) Patentinhaber: **Siemens Aktiengesellschaft**
**Wittelsbacherplatz 2**
**D-8000 München 2 (DE)**

(72) Erfinder: **Unger, Bernhardt, Dr.**
**Wolfratshauser Strasse 177**
**D-8000 München 71 (DE)**
Erfinder: **Rauschert, Rainer, Dr.**
**Otto-Bezold-Weg 22**
**D-8000 München 83 (DE)**

Courier Press, Leamington Spa, England.

**Beschreibung**

Die Erfindung bezieht sich auf ein Verfahren und Schaltungsanordnungen zur Feststellung von verdeckten Fehlern in internen Schaltungsteilen bei der Prüfung von integrierten Bausteinen nach den Oberbegriffen der Patentansprüche 1, 4, 5.

Bei hoch integrierten Bausteinen (LSI-Bausteine) besteht für die internen Schaltungsanordnungen kein direkter Zugriff von außen. Es ist deshalb nur eine Funktionsprüfung, aber keine Prüfung der Störsicherheit der internen Schaltungsteile möglich. Schaltungsteile mit verminderter Störsicherheit, bedingt durch Technologieschwächen werden bei der Bausteinprüfung meistens nicht erkannt, da die Prüfungen nicht unter den "worst case"-Bedingungen, wie sie im Einsatzfall auftreten, durchgeführt werden können.

Durch die DE—A—30 40 733 ist bereits ein Verfahren zur Untersuchung von integrierten Schaltungsanordnungen, insbesondere Speicherbausteinen, bekannt, bei dem vorzugsweise Schaltungsteile mit ohnehin geringer Störsicherheit zu weiterer Verminderung der Störsicherheit einer gezielten Einwirkung von α-Strahlung auf ausgewählte Bereiche ausgesetzt werden und das dadurch ausgelöste Fehlverhalten beobachtet wird. Das bekannte Verfahren ist jedoch recht aufwendig und daher vorteilhaft nur in der Entwicklungsphase, beispielsweise zur Untersuchung erster Fertigungsmuster anwendbar.

Aus der US—A—3,577,073 ist bereits eine Steuerschaltung zur Steuerung eines Referenzspannungsgenerators, an den integrierte Bausteine in CML-Schaltungstechnik angeschlossen sind, bekannt. Durch Veränderung der Referenzspannung für den CML-Logikschaltkreis können dabei an der Grenze liegende Spannungs- und Schaltkreisfehler festgestellt werden. Eine Veränderung des Signalhubes zum Zwecke der Verringerung des Störabstandes ist mit einer solchen Schaltungsanordnung jedoch nicht möglich.

Der Erfindung liegt die Aufgabe zugrunde, ein auch für große Stückzahlen geeignetes Verfahren zur Feststellung von verdeckten Fehlern in internen Schaltungsteilen von integrierten Bausteinen und Schaltungsanordnungen zur Durchführung des Verfahrens anzugeben. Diese Aufgabe wird durch die kennzeichnenden Merkmale des Patentanspruchs 1 bzw. der Ansprüche 4 und 5 gelöst.

Die Erfindung wird im folgenden anhand der Zeichnung näher beschrieben. Es zeigt

Fig. 1 eine CML-Grundschaltung,

Fig. 2 Signalpegel und Referenzpotentiale einer CML-Schaltung im Normal- und Testbetrieb,

Fig. 3 einen steuerbaren Referenzspannungsgenerator,

Fig. 4 eine erste Steuerschaltung zur gezielten Reduzierung der Störsicherheit,

Fig. 5 Signalpegel und Referenzpotentiale als Funktion der Versorgungsspannungen und

Fig. 6 eine zweite Steuerschaltung.

Das angegebene Verfahren zur Feststellung verdeckter Fehler in integrierten Bausteinen in CML-Schaltungstechnik kann während der Entwicklungsphase solcher Bausteine zum Aufspüren von grundsätzlich vorhandenen Schwachstellen, beispielsweise infolge einer ungünstigen Leitungsführung oder Schaltungsauslegung, eingesetzt werden. Das Verfahren ist jedoch vor allem für die Verwendung bei Routineprüfungen, zum Beispiel bei der Eingangskontrolle von integrierten Bausteinen vorgesehen, um auch solche Bausteine zu erfassen, die bei der statischen Prüfung unter normalen Betriebsbedingungen nach außen hin zwar fehlerfrei erscheinen, aber trotzdem aufgrund von Technologiemängeln Schwachstellen aufweisen. Durch die einer Verkleinerung des Signalhubs proportionale Reduzierung des Störabstands können solche Schwachstellen erkannt werden.

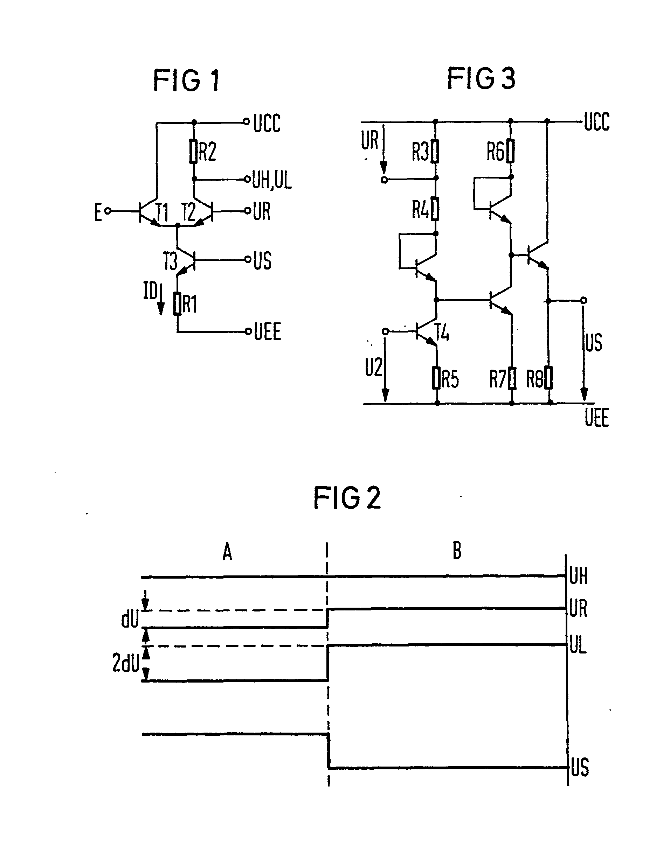

Zum besseren Verständnis der im kennzeichnenden Teil des Patentanspruchs 1 verwendeten Größen ist in Fig. 1 eine bekannte Grundschaltung in CML-, insbesondere ECL-Schaltungstechnik dargestellt. Die Grundschaltung enthält einen Differenzverstärker mit zwei Transistoren T1 und T2, deren Emitter verbunden sind. Der Differenzverstärker wird mit einem konstanten Strom ID betrieben, der von einer Stromquellenschaltung aus dem Transistor T3 und seinem Emitterwiderstand R1 geliefert wird. Die Basis des Stromquellentransistors T3 liegt auf einem Referenzpotential US, im folgenden als Stromquellenreferenz bezeichnet.

Die Basis des einen Transistors T1 des Differenzverstärkers bildet den Signaleingang E für ein binäres Eingangssignal. Die Basis des zweiten Transistors T2 wird auf einem weiteren Referenzpotential UR gehalten, das dem Mittelwert zwischen dem oberen und dem unteren Pegel des binären Eingangssignals entspricht und nachstehend als Stromschalterreferenz bezeichnet wird.

Die Versorgungsspannung für die CML-Schaltungsanordnung wird über die Anschlußpunkte UCC und UEE angelegt. Das Potential des kollektorseitigen Anschlußpunktes UCC dient als Bezugspotential, das heißt andere Potentiale, insbesondere die Signalpegel UH und UL und die Stromschalterreferenz UR bzw. bei zwei- oder dreistufiger Serienkopplung auch die entsprechenden weiteren Stromschalterreferenzen werden auf UCC bezogen. Eine Ausnahme macht die Stromquellenreferenz US insofern als hierbei der Potentialunterschied gegen den emitterseitigen Anschlußpunkt UEE neben der Bemessung des Emitterwiderstandes R1 für die Größe des von der Stromquellenschaltung gelieferten Stroms maßgebend ist.

Da in der CML-Grundschaltung nach Fig. 1 nur ein gegen das Eingangssignal nicht invertiertes Ausgangssignal mit den Signalpegeln UH und UL am Kollektor des Transistors T2 abgenommen wird, ist nur für diesen Transistor T2 ein Arbeitswiderstand R2 vorgesehen, während der Kollektor des Transistors T1 unmittelbar mit dem Bezugspotentialpunkt UCC verbunden ist.

Bekanntlich stellt sich der hohe Signalpegel UH des Ausgangssignals dann ein, wenn der Transistor (T2 in Fig. 1), an dessen Kollektor das Aus-

gangssignal abgenommen wird, stromlos ist. Sieht man von dem zumeist geringen Einfluß einer eventuellen Ausgangsbelastung ab, dann entspricht der obere Signalpegel UH dem Bezugspotential UCC und ist durch Maßnahmen, die nur während der Prüfung wirksam werden sollen, nicht veränderbar. Der untere Signalpegel UL ergibt sich durch den Spannungsabfall, den der volle, von der Stromquellenschaltung gelieferte Strom ID am Kollektorwiderstand R2 hervorruft.

Soll also der Signalhub ΔU, d.h. der Unterschied zwischem dem oberen und dem unteren Signalpegel UH bzw. UL verringert werden, dann gelingt das durch die Anhebung des unteren Signalpegels UL um einen Betrag 2 dU. Dies wiederum wird durch das Absenken der Stromquellenreferenz US, das heißt durch die Verkleinerung der Basisvorspannung für den Stromquellentransistor T3 erreicht, weil dadurch der Differenzverstärkerstrom ID und der Spannungsabfall am Kollektorarbeitswiderstand R2 des leitenden Transistors (T2) im Differenzverstärker herabgesetzt wird.

Die beschriebene Maßnahme würde jedoch für sich allein wegen der einseitigen Reduzierung des Störabstands noch nicht zu dem gewünschten Ergebnis führen. Vielmehr ist es zusätzlich erforderlich, die Stromschalterreferenz UR so weit, nämlich um den Betrag dU anzuheben, daß sie wieder dem Mittelwert aus dem oberen Signalpegel UH und dem veränderten unteren Signalpegel UL entspricht.

Die gegenseitige Zuordnung der für CML-Schaltungsanordnungen wesentlichen Potentiale zeigt die Fig. 2, und zwar im linken Abschnitt A für normale Betriebsbedingungen und im rechten Abschnitt B für Prüfbedingungen. Insbesondere sind die vorher ausführlich erläuterten Veränderungen der Potentiale ohne weiteres erkennbar.

Zur Erzeugung der Stromquellen- und Stromschalterreferenzen US und UR dienen Referenzspannungsgeneratoren (Biasdriver), die in integrierten Schaltungsanordnungen jeweils für bestimmte Schaltungskomplexe gemeinsam vorgesehen sind. Solche Referenzspannungsgeneratoren sind bekannt (vergl. zum Beispiel Tagungsbericht ESSCIRC, 22. bis 24.09.1981, S. 205 bis 207, DE—C—28 49 153). Sie sind im allgemeinen temperaturkompensiert und in weiten Grenzen von Änderungen der Versorgungsspannung unabhängig.

Für den vorliegenden Zweck müssen jedoch die Referenzpotentiale US und UR gezielt veränderbar sein. Dies wird durch Auftrennen einer internen Rückkopplung (zum Beispiel Basisanschluß des Transistors T3 in DE—C—28 49 153) und Einspeisung einer veränderbaren Hilfsspannung erreicht. Einen entsprechend abgewandelten Referenzspannungsgenerator zeigt die Fig. 3. Unter der Voraussetzung, daß für die Widerstände die Beziehungen R6=R7 und R8=R3+R4 gelten, sind die Referenzen UR und US proportional zu einer zwischen der Basis des Transistors T4 und dem Anschluß UEE der Versorgungsspannung herrschenden Spannung U2 vermindert um den Spannungsabfall UBE zwischen der Basis und dem Emitter eines leitenden Transistors.

Im einzelnen gilt:

$$UR = (U2 - UBE) \cdot \frac{R3}{R5}$$

und

$$US = (U2 - UBE) \cdot \frac{R8}{R5}$$

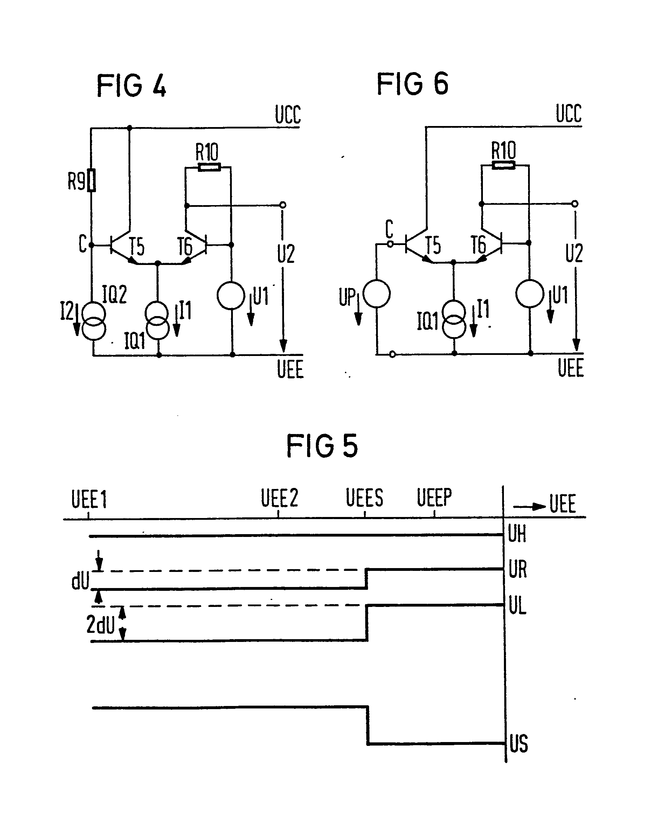

Eine Steuerschaltung zur Steuerung eines Referenzspannungsgenerators nach Fig. 3 durch Ausgabe einer Hilfsspannung U2, die zwei verschiedene Werte annehmen kann, ist in Fig. 4 dargestellt. Die Steuerschaltung enthält zwei Transistoren T5 und T6, deren Emitter miteinander und mit einer Stromquellenschaltung IQ1 zur Lieferung eines Stroms I1 verbunden sind. Der Kollektor des Transistors T5 ist mit dem Bezugspotential UCC=0 V verbunden. Seine Basis liegt am Verbindungspunkt C eines an das Bezugspotential UCC angeschlossenen Widerstands R9 und einer weiteren mit dem Anschlußpunkt UEE verbundenen Stromquellenschaltung IQ2 für einen Strom 12.

Die Basis des zweiten Transistors T6 erhält eine konstante Vorspannung U1 gegen den emitterseitigen Pol UEE der Versorgungsspannung. Die Vorspannung U1 wird von einem voll spannungs- und temperaturkompensierten Referenzspannungsgenerator geliefert. Von ihr werden auch die Referenzspannungen für die Stromquellen IQ1 und IQ2 abgeleitet. Zwischen der Basis und dem Kollektor des Transistors T6 ist ein Widerstand R10 angeordnet. Die Ausgangsspannung U2 wird am Kollektor des Transistors T6 abgenommen.

Die Steuerschaltung nach Fig. 4 ist so ausgelegt, daß ihre Aktivierung durch eine Verkleinerung der Versorgungsspannung zwischen den Anschlußpunkten UCC und UEE, die wegen der Zuordnung des Bezugspotentials zum Anschlußpunkt UCC im folgenden als Versorgungsspannung UEE bezeichnet wird, erfolgt. Durch eine zweckentsprechende Festlegung des Spannungsabfalls am Widerstand R9 wird erreicht, daß beim Normalwert der Versorgungsspannung UEE bzw. im Betriebsbereich

$$|UEE1| \geq |UEE| \geq |UEE2|$$

gilt:

$$|UEE| - 12 \cdot R9 > U1.$$

Damit führ der Transistor T5 den Strom I1 und der Transistor T6 ist stromlos mit der Folge U2=U1.

Im Prüfbetrieb wird die Versorgungsspannung UEE auf einen Wert UEEP herabgesetzt, für den die Bedingung gilt.

$$|UEEP| - I2 \cdot R9 < U1$$

Der Strom I1 fließt dann durch den Transistor T6 und es ergibt sich

$$U2 = U1 - I1 \cdot R10 < U1.$$

Der in Fig. 3 dargestellte Referenzspannungsgenerator bewirkt damit eine Verkleinerung der Spannungen UR und US, das heißt ein Anheben der Stromschalterreferenz UR bzw. ein Absenken der Stromquellenreferenz US gegen UEE.

Den Einfluß der Versorgungsspannung UEE auf die CML-Signalpegel und Referenzen zeigt die Fig. 5 als Diagramm. Es ist darauf hinzuweisen, daß die Spannungen UR and US, abgesehen von einem schmalen Bereich um den Wert UEES, sowohl innerhalb des Betriebsbereichs als auch innerhalb des Prüfbereichs konstant sind.

Bei der während der Prüfung eingestellten Versorgungsspannung UEEP müssen die in LSI-Bausteinen eingesetzten Ausgangsstufen nur so weit funktionsfähig sein, daß die nach außen abgegebenen Signalpegel eindeutig identifizierbar sind, da nur auf interne Funktionsfähigkeit und nicht auf die Einhaltung von Parametern geprüft wird. Weiter ist bei der Wahl der Versorgungsspannung UEEP darauf zu achten, daß die Transistoren der zu prüfenden Schaltungsanordnung nicht in Sättigung geraten, wodurch möglicherweise Fehler vorgetäuscht werden könnten.

Eine gegen die Steuerschaltung nach Fig. 4 geringfügig abgewandelte Steuerschaltung kann durch Erhöhung anstatt durch Verringerung der Versorgungsspannung UEE aktiviert werden. Da hierbei aber eine Erhöhung der Verlustleistung eintritt, ist diese Möglichkeit ungünstiger.

Die Gefahr für das Auftreten von unerwünschten Nebenwirkungen bei der Prüfung von integrierten Bausteinen kann vermieden werden, wenn die Steuerschaltung nicht durch die Änderung der Versorgungsspannung UEE sondern durch eine von außen zugeführte Steuerspannung UP aktiviert wird.

Hierzu werden bei der Steuerschaltung nach Fig. 4 der Widerstand R9 und die Stromquelle IQ2 entfernt und die Steuerspannung UP zwischen dem Anschlußpunkt UEE und dem Punkt C (Basis des Transistors T5) angelegt.

Für die Steuerspannung gilt dann

im Normalbetrieb UP>U1

und

im Prüfbetrieb UP<U1.

Die geänderte Steuerschaltung zeigt die Fig. 6.

Dem Vorteil des Betriebs bei normaler Versorgungsspannung steht als Nachteil gegenüber, daß mindestens ein zusätzlicher Anschlußstift und einige zusätzliche interne Leitungen, die die Steuerspannung UP zu den Referenzspannungsgeneratoren führen, benötigt werden.

Bezugszeichenliste

| | |
|---|---|
| ΔU | Signalhub |
| 2dU | Verkleinerung des Signalhubes |
| UP | Steuersignal |
| UH | hoher Signalpegel |
| UL | niedriger Signalpegel |
| UR | Referenzpotential |
| US | Stromquellenreferenzspannung |
| UCC | Kollektorpotential |
| UEE | Emitterpotential |
| U1 | Vorspannung |
| U2 | Ausgangsspannung |
| ID | Konstantstrom |
| IQ1 | Stromquelle 1 |
| IQ2 | Stromquelle 2 |
| UEE1 | Emitterspannung 1 |
| UEE2 | Emitterspannung 2 |
| UEEP | Prüfversorgungsspannung |
| UEES | Prüfreferenzspannung |
| J1 | Strom der Stromquelle IQ1 |
| J2 | Strom der Stromquelle IQ2 |
| T1 | Transistor 1 eines Differenzverstärkers |
| T2 | Transistor 2 eines Differenzverstärkers |
| T3 | Transistor der Stromquelle |
| T4 | Transistor der Stromquelle |
| T5 | Transistor der Steuerschaltung |
| T6 | Transistor der Steuerschaltung |
| R1 | Emitterwiderstand |
| R2 | Arbeitswiderstand |
| R3 | Widerstand der Stromquelle |
| R4 | Widerstand der Stromquelle |
| R5 | Widerstand |
| R6 | Widerstand |
| R7 | Widerstand |
| R8 | Widerstand |
| R9 | Widerstand |
| R10 | Widerstand |

**Patentansprüche**

1. Verfahren zur Feststellung von verdeckten Fehlern in internen Schaltungsteilen eines zu prüfenden integrierten Logikbausteins in CML-Schaltungstechnik durch gezielte Reduzierung des Störabstandes in den internen Schaltungsteilen, dadurch gekennzeichnet, daß der aus dem Unterschied zwischen dem oberen und dem unteren Signalpegel (UH, UL) resultierende Signalhub (ΔU) mit Hilfe einer bausteininternen Steuerschaltung zur Steuerung eines Referenzpotentiale (UR, US) erzeugenden Referenzspannungsgenerators für den Logikbaustein in CML-Schaltungstechnik derart vermindert wird, daß eine der Verkleinerung (2dU) des Signalhubs (ΔU) proportionale, symmetrische Reduzierung des Störabstandes in Bezug auf die beiden binären Signalpegel (UH) und (UL) der Ausgangssignale des Logikbausteins erzielt wird.

2. Verfahren nach Anspruch 1, dadurch gekennzeichnet, daß die Steuerschaltung durch Variation der Betriebsspannung um einen vorgegebenen Betrag aktiviert wird.

3. Verfahren nach Anspruch 1, dadurch gekennzeichnet, daß die Steuerschaltung durch ein externes Steuersignal (UP) aktivert wird.

4. Schaltungsanordnung zur Feststellung von verdeckten Fehlern in internen Schaltungsteilen eines zu prüfenden integrierten Logikbausteins in CML-Schaltungstechnik durch gezielte Reduzierung des Störabstandes in den internen Schaltungsteilen, zur Durchführung des Verfahrens nach Anspruch 2, dadurch gekennzeichnet, daß ein Referenzspannungsgenerator mit dem Logikbaustein verbunden ist und daß eine Steuerschaltung zur Steuerung des Referenzspannungsgenerators zwei Transistoren (T5, T6) aufweist, deren Emitter miteinander und mit einer ersten Konstantstromquelle (IQ1) zur Lieferung eines ersten Stroms (I1) verbunden sind, daß die Basis des ersten Transistors (T6) eine konstante Vorspannung (U1) gegen den emitterseitigen Anschlußpunkt (UEE) der Versorgungsspannung erhält, daß zwischen der Basis des ersten Transistors (T6) und seinem Kollektor, an dem eine Ausgangsspannung (U2) abgenommen wird, ein Widerstand (R10) angeordnet ist, daß die Basis des zweiten Transistors (T5) an den Verbindungspunkt (C) eines weiteren Widerstands (R9) mit einer zweiten Konstantstromquelle (IQ2) zur Erzeugung eines zweiten Stroms (I2) angeschlossen ist, daß die Serienschaltung aus dem weiteren Widerstand (R9) und der zweiten Konstantstromquelle (IQ2) zwischen die Anschlußpunkte (UCC, UEE) der Versorgungsspannung geschaltet ist, wobei die zweite Konstantstromquelle (IQ2) einseitig mit dem emitterseitigen Anschlußpunkt (UEE) verbunden ist und daß der zweite Strom (I2) und der weitere Widerstand (R9) so bemessen sind, daß der zweite Transistor (T5) im Betriebsbereich des Logikbausteins bei normaler Versorgungsspannung stromführend und im Prüfbereich des Logikbausteins bei herabgesetzter Versorgungsspannung stromlos ist.

5. Schaltungsanordnung zur Feststellung von verdeckten Fehlern in internen Schaltungsteilen eines zu prüfenden integrierten Logikbausteins in CML-Schaltungstechnik durch gezielte Reduzierung des Störabstandes in den internen Schaltungsteilen zur Durchführung des Verfahrens nach Anspruch 3, dadurch gekennzeichnet, daß ein Referenzspannungsgenerator mit dem Logikbaustein verbunden ist und daß eine Steuerschaltung zur Steuerung des Referenzspannungsgenerators zwei Transistoren (T5, T6) aufweist, deren Emitter miteinander und mit einer ersten Konstantstromquelle (IQ1) zur Lieferung eines Stroms (I1) verbunden sind, daß die Basis des ersten Transistors (T6) eine konstante Vorspannung (U1) gegen den emitterseitigen Anschlußpunkt (UEE) der Versorgungsspannung erhält, daß zwischen der Basis des ersten Transistors (T6) und seinem Kollektor, an dem eine Ausgangsspannung (U2) abgenommen wird, ein Widerstand (R10) angeordnet ist und daß ein externes Steuersignal (UP) zwischen der Basis des zweiten Transistors (T5) und dem emitterseitigen Anschlußpunkt (UEE) der Versorgungsspannung angelegt wird und dieses Steuersignal (UP) so bemessen ist, daß es im Betriebsbereich des Logikbausteins größer und im Prüfbereich des Logikbausteins kleiner als die konstante Vorspannung (U1) ist.

**Revendications**

1. Procédé pour détecter des défauts masqués dans des éléments de circuit intégrés d'un module logique intégré réalisé selon la technique des circuits CML et devant être testé, au moyen d'une réduction volontaire du rapport signal/bruit dans les éléments de circuit internes, caractérisé par le fait qu'on réduit l'excursion (DU) d'un signal, qui résulte de la différence entre le niveau supérieur et le niveau inférieur (UH, UL) du signal, à l'aide d'un circuit de commande situé à l'intérieur du module et servant à commander un générateur de tension de référence, qui produit des potentiels de référence (UR, US), pour le module logique réalisé selon la technique des circuits CML, de manière à obtenir une réduction symétrique, proportionnelle à la réduction de (2dU) de l'excursion (DU) du signal, du rapport signal/bruit en référence aux deux niveaux binaires (UH) et (UL) des signaux de sortie de module logique.

2. Procédé suivant la revendication 1, caractérisé par le fait que le circuit de commande est activé au moyen d'une variation, d'une valeur prédéterminée, de la tension de service.

3. Procédé suivant la revendication 1, caractérisé par le fait que le circuit de commande est activé au moyen d'un signal externe de commande (UP).

4. Montage pour détecter des défauts masqués dans des éléments de circuit intégrés d'un module logique intégré devant être réalisé selon la technique des circuits CML, et devant être testé, au moyen d'une réduction volontaire du rapport signal/bruit dans les éléments de circuit internes, pour la mise en oeuvre du procédé suivant la revendication 2, caractérisé par le fait que le générateur de tension de référence est relié à un module logique et que son circuit de commande servant à commander le générateur de tensions de référence comporte deux transistors (T5, T6), dont les émetteurs sont reliés entre eux et à une première source de courant constant (IU) servant à délivrer un premier courant (I1), que la base du premier transistor (T6) reçoit une tension de polarisation constante par rapport à la borne (UEE), située du côté émetteur, de la tension d'alimentation, qu'une résistance (R10) est montée entre la base du premier transistor (T6) et son collecteur, sur lequel est prélevée une tension de sortie (U2), que la base du second transistor (T5) est raccordée au point de jonction (C) d'une autre résistance (R9) possédant une seconde source de courant constant (IQ2) servant à produire un second courant (I2), que le circuit série formé de l'autre résistance (R9) et de la seconde source de courant constant (I2) est branché entre les bornes (ICC, IEE) de la tension d'alimentation, la seconde source de courant constant (IQ2) étant reliée, côté entrée, à la borne (IEE) située côté émetteur, et que le second courant (I2) et l'autre résistance (R9) sont dimensionnés de manière que le second transistor (T5) véhicule le courant dans la plage de fonctionnement du module logique, dans le cas de la présence d'une tension d'alimentation normale, et n'est pas alimenté en courant dans la plage de contrôle du module logique, dans le cas où la tension d'alimentation est réduite.

5. Montage pour détecter des défauts masqués dans des éléments de circuit intégrés d'un module logique intégré devant être réalisé selon la technique des circuits CML, et devant être testé, au moyen d'une réduction volontaire du rapport signal/bruit dans les éléments de circuit internes, pour la mise en oeuvre du procédé suivant la revendication 3, caractérisé par le fait que le générateur de tensions de référence est relié à un module logique et que son circuit de commande servant à commander le générateur de tensions de référence comporte deux transistors (T5, T6), dont les émetteurs sont reliés entre eux et à une première source de courant constant (IU) servant à délivrer un premier courant (I1), que la base du premier transistor (T6) reçoit une tension de polarisation constante (U) par rapport à la borne (UEE) située du côté émetteur, de la tension d'alimentation, qu'une résistance (R10) est disposée entre la base du premier transistor (T6) et son collecteur, sur lequel est prévue une tension de sortie (U2), et qu'un signal externe de commande (UP) est appliqué entre la base du second transistor (T5) et la borne (UEE), située côté émetteur, de la tension d'alimentation et que ce signal de commande (UP) est dimensionné de telle sorte que dans la gamme de fonctionnement du module logique, il est supérieur à la tension de polarisation constante (UE) et que dans la gamme de contrôle du module logique, il est inférieur à cette tension.

**Claims**

1. Method for detecting concealed faults in internal circuit parts of an integrated logic component that employs CML circuitry and is to be tested, by specific reduction of the signal-to-noise ratio in the internal circuit parts, characterized in that the signal swing (ΔU) resulting from the difference between the upper and the lower signal level (UH, UL) is reduced with the assistance of a component-internal control circuit for controlling a reference voltage generator generating reference potentials (UR, US) for the logic component employing CML circuitry in such a way that a symmetrical reduction of the signal-to-noise ratio, proportional to the reduction (2dU) of the signal swing (ΔU), is achieved with respect to the two binary signal levels (UH) and (UL) of the output signals of the logic component.

2. Method according to Claim 1, characterized in that the control circuit is activated by varying the operating voltage by a predetermined amount.

3. Method according to Claim 1, characterized in that the control circuit is activated by an external control signal (UP).

4. Circuit arrangement for detecting concealed faults in internal circuit parts of an integrated logic component that employs CML circuitry and is to be tested, by specific reduction of the signal-to-noise ratio in the internal circuit parts, for carrying out the method according to Claim 2, characterized in that a reference voltage generator is connected to the logic component, and in that a control circuit for controlling the reference voltage generator has two transistors (T5, T6), whose emitters are connected to each other and to a first constant current source (IQ1) for supplying a first current (I1), in that the base of the first transistor (T6) receives a constant bias (U1) against the emitter-side connection point (UEE) of the supply voltage, in that a resistor (R10) is arranged between the base of the first transistor (T6) and its collector where an output voltage (U2) is picked up, in that the base of the second transistor (T5) is connected at the connection point (C) of a further resistor (R9) to a second constant current source (IQ2) for generating a second current (I2), in that the series circuit of the further resistor (R9) and the second constant current source (IQ2) is connected between the connection points (UCC, UEE) of the supply voltage, the second constant current source (IQ2) being connected on one side to the emitter-side connection point (UEE), and in that the second current (IQ) and the further resistor (R9) are dimensioned in such a way that the second transistor (T5) carries current in the operating range of the logic component in the case of normal supply voltage, and is without current in the testing range of the logic component with reduced supply voltage.

5. Circuit arrangement for detecting concealed faults in internal circuit parts of a logic component that employs CML circuitry and is to be tested, by specific reduction of the signal-to-noise ratio in the internal circuit parts, for carrying out the method according to Claim 3, characterized in that a reference voltage generator is connected to the logic component, and in that a control circuit for controlling the reference voltage generator has two transistors (T5, T6), whose emitters are connected to each other and to a first constant current source (IQ1) for supplying a current (I1), in that the base of the first transistor (T6) receives a constant bias (U1) against the emitter-side connection point (UEE) of the supply voltage, in that a resistor (R10) is arranged between the base of the first transistor (T6) and its collector where an output voltage (U2) is picked up, and in that an external control signal (UP) is applied between the base of the second transistor (T5) and the emitter-side connection point (UEE) of the supply voltage, and this control signal (UP) is dimensioned in such a way that in the operating range of the logic component it is greater than the constant bias (U1) and is smaller than the latter in the testing range of the logic component.

# FIG 1

# FIG 3

# FIG 2

# FIG 4

# FIG 6

# FIG 5